# FASCICULE DE BREVET EUROPEEN

(11) **EP 0 793 269 B1**
(45) Date de publication et mention de la délivrance du brevet: **15.05.2002**
(21) Numéro de dépôt: 97200480.8
(22) Date de dépôt: 19.02.1997
(51) Int. Cl.: H01L 21/60, H01L 23/48

(54) **Dispositif semiconducteur incluant une puce munie d'une ouverture de via et soudée sur un support, et procédé de réalisation de ce dispositif**
Halbleiteranordnung mit einem auf einen Träger gelöteten Chip mit Durchgangsleitungen und Herstellungsverfahren dafür
Semiconductor device having a chip with via hole soldered on a support, and its method of fabrication

(30) Priorité: 28.02.1996 FR 9602492
(43) Date de publication de la demande: 03.09.1997
(73) Titulaire: Koninklijke Philips Electronics N.V., 5621 BA Eindhoven (NL)
(72) Inventeur: Baudet, Pierre, 156, Boulevard Haussmann 75008 Paris (FR)
(74) Mandataire: Lottin, Claudine

(56) Documents cités:
- EP-A- 0 469 988
- EP-A- 0 627 765
- EP-A- 0 631 313
- US-A- 5 350 662
- PATENT ABSTRACTS OF JAPAN vol. 014, no. 421 (E-0976), 11 Septembre 1990 & JP 02 162735 A (FUJITSU LTD), 22 Juin 1990,

## Description

L'invention concerne un dispositif semiconducteur comprenant une puce incluant un substrat semiconducteur ayant une face avant et une face arrière, un élément conducteur d'un circuit sur ladite face avant, une ouverture de VIA s'étendant à travers le substrat et ayant des parois latérales et un fond coïncidant avec l'élément conducteur, une couche conductrice appelée plan de masse couvrant ladite face arrière et les parois latérales et le fond de l'ouverture de VIA et connectant l'élément conducteur, et un support avec une face réceptrice sur laquelle la puce est soudée par sa face arrière.

L'invention concerne aussi un procédé de réalisation de ce dispositif.

L'invention trouve son application dans l'industrie des circuits intégrés et tout particulièrement des circuits hyperfréquences monolithiquement intégrés sur un substrat en arséniure de gallium (MMICs).

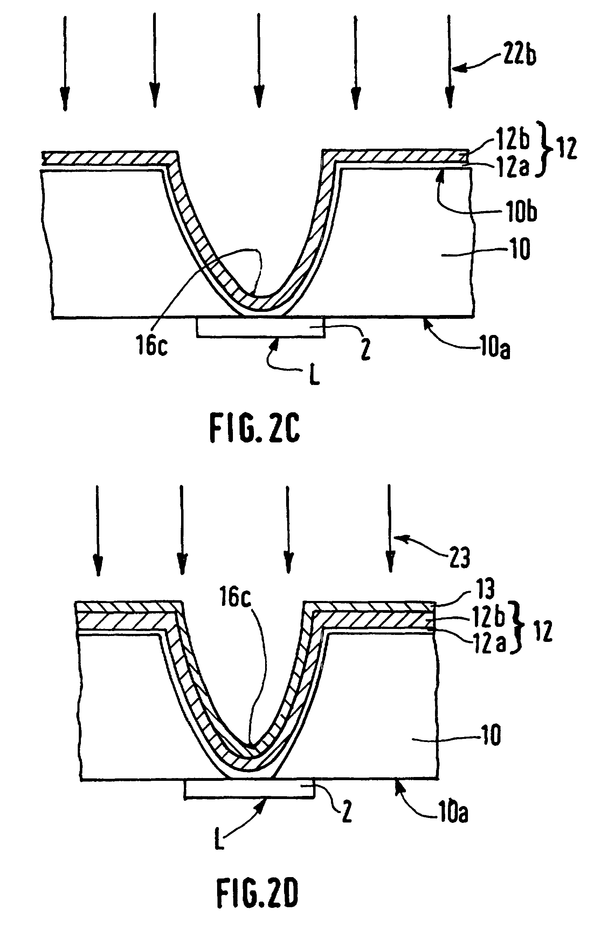

Un tel dispositif et un procédé pour le réaliser sont déjà connus du brevet du Japon JP 02 162 735 (PATENT ABSRACTS OF JAPAN vol. 014, no. 421, E-0976, du 11 Septembre 1990, FUJITSU LTD, date de publication: 22 Juin 1990). Ce document décrit une méthode proposant des moyens pour prévenir la génération de craquelures dues à la soudure. Selon cette méthode, une ouverture de VIA est formée entre des électrodes disposées à l'arrière et à l'avant d'un substrat semiconducteur et l'électrode de la face arrière couvre les parois du VIA et la face arrière de l'électrode de la face avant du substrat. Un film non-mouillable par un métal de brasure est déposé à l'intérieur du VIA, sur les parois de ce VIA et sur l'arrière de l'électrode de la face avant. L'électrode de la face arrière est soudée sur un support. L'électrode de la face arrière est constituée par une couche d'or (Au). La couche non-mouillable est en nickel (Ni). Lorsque l'électrode en or est soudée sur le support, il se forme une cavité à l'intérieur du VIA qui est dépourvue de soudure. Les craquelures produites par des tensions dues à la soudure dans la fine couche à la partie supérieure du VIA sont ainsi évitées. Les figures 2C, 2D montrent que la couche non-mouillable s'arrête à la face arrière du substrat et que le métal de brasure ne monte pas dans la cavité du VIA.

Un procédé pour souder une puce sur support sans utiliser de masque est connu du brevet US 5 350 662 (Chi, Sep. 27, 1994). Ce procédé comprend la formation de VIA entre un élément de circuit sur la face avant d'un substrat semiconducteur et une couche conductrice sur la face arrière, pour assurer la connexion avec cet élément de circuit; la formation sur la face arrière de ladite couche conductrice et d'une couche non-mouillable par les agents de soudure, couches qui couvrent également les parois du VIA et la face inférieur de l'élément de circuit; l'élimination des portions de la couche non-mouillable situées sur la face arrière du substrat à l'exception des portions situées dans le VIA; et la soudure du substrat par sa face arrière sur un support. Il apparaît que la couche non-mouillable couvre les parois du VIA de telle sorte que l'agent de soudure ne s'introduit pas dans le VIA. Ce procédé évite les craquelures qui apparaissent lorsque l'agent de soudure s'introduit dans le VIA. Ce procédé ne nécessite pas d'étape de masquage pour réaliser l'élimination des portions de couche non-mouillable externes au VIA pendant que la cavité du VIA est protégée par du photorésist.

Un procédé d'interconnexion entre un circuit intégré et un circuit support est connu du brevet EP 0 469 988 (publié le 05.02.92). Selon ce procédé, une puce de circuit intégré est fixée sur un support par brasure des métallisations de plan de masse. Les plots d'entrées-sorties du circuit intégré sont réunies aux pistes métallisées dur du support par l'intermédiaire de trous métallisés. Pour la soudure, une préforme de soudure tendre assez fine est mise en place pour que, au cours de sa fusion, elle se divise en fragments, qui par force de capillarité prennent les contours des plages métalliques à braser.

Un autre dispositif et un procédé pour le réaliser sont déjà connus de la demande de brevet européen EP 631 313 de la Demanderesse MITSUBISHI DENKI KABUSHIKI KAISHA (Référence KOSAKI). Le dispositif connu comprend, outre les éléments décrits plus haut, une couche en un matériau approprié à empêcher l'adhérence du matériau de soudure utilisé pour fixer la face arrière de la puce sur le support Selon le document cité, ladite couche de matériau empêchant l'adhérence est déposée en surface du plan de masse sur la face arrière du substrat de manière à ne couvrir que le fond du VIA métallisé. Cette couche antiadhérence est arrêtée à une distance d du fond du VIA qui est calculée en fonction de la résistance de rupture de matériau de substrat, et qui est de 73,7 µm pour un substrat en arséniure de gallium d'épaisseur 150 µm. Par soudure de la face arrière sur un support, le matériau de soudure en Au-Sn monte à l'intérieur du VIA le long des parois de VIA dépourvues de ladite couche antiadhérence et s'arrête strictement au niveau de la couche antiadhérence. Ainsi un espace libre dépourvu de soudure est formé sur une hauteur d = 73,7 µm mesurée à partir du fond du VIA, et calculée en fonction de l'épaisseur du substrat égale à 150 µm. Il faut noter que la surface supérieure du matériau de soudure Au-Sn à l'intérieur du VIA est plane et parallèle aux faces avant et arrière du dispositif, ou bien montre une concavité creusée vers le bas du VIA. Il faut noter aussi que le matériau de soudure Au-Sn adhère fortement à la partie basse des parois du VIA à peu près sur la moitié de la hauteur du VIA, où ces parois sont dépourvues de couche antiadhérence. La hauteur d'adhérence est en effet égale à la hauteur du VIA qui est 150 µm diminuée de la hauteur de l'espace libre qui est d = 73,7 µm. Il faut noter encore que la formation de la couche antiadhérence de hauteur d implique l'emploi d'une étape spécifique de masquage dans le procédé de réalisation.

La référence KOSAKI veut être la solution à deux problèmes techniques exposés qui se posent dans la fabrication des puces munies de VIAS et soudées sur un support. Un premier problème technique apparaît dans le cas où la face arrière du dispositif et l'intérieur du VIA sont simplement munis d'un plan de masse formé d'une couche d'or favorisant l'adhérence du matériau de soudure Au-Sn. Lors de l'opération de soudure sur le support au moyen du matériau Au-Sn, ce matériau de soudure monte spontanément dans le VIA par mouillage de l'or et emplit le VIA entièrement, puis il produit des crevasses dans le substrat par rétractation lors du refroidissement, comme montré sur les FIGS.20a et 20b du document cité. Un deuxième problème technique apparaît dans le cas où la totalité des parois du VIA est munie d'une couche empêchant le mouillage, à l'exclusion des autres parties du plan de masse à la face arrière de la puce. Lors de l'opération de soudure sur un support, ce matériau de soudure Au-Sn ne monte pas du tout dans le VIA, comme il est montré sur la FIG.21 du document cité. Dans ce cas, la puce soudée montre un problème de dissipation thermique.

Dans le cadre de l'étude qui a mené à la présente invention, d'autres problèmes techniques sont apparus. D'abord, en référence au premier problème technique cité illustré par lesdites FIG.20a, 20b, non seulement des crevasses apparaissent dans le substrat autour du VIA, mais encore la couche d'or qui sert à la fois de plan de masse et de couche de mouillage a tendance à se décoller dans le fond du VIA. En outre, la soudure a tendance à créer des fissures aussi dans l'élément de circuit supérieur. Il en résulte donc une conséquence néfaste non citée qui est la rupture possible du plan de masse. Ensuite, en référence au second problème cité, illustré par ladite FIG.21, l'expérience montre que, dans le cas d'un dispositif muni d'une pluralité de VIAS avec couche interne antimouillage, il n'est pas exact que la soudure ne monte pas du tout à l'intérieur des VIAS. En général, la soudure monte d'une certaine quantité aléatoire dans chaque VIA, ce qui peut engendrer en contrepartie des manques de soudure ou bulles sur les parties planes de la face arrière entre les VIAS. Il en résulte une conséquence néfaste qui est que le dispositif est très mal soudé. D'autre part, comme le substrat semiconducteur est très mince et très cassant, il en résulte une autre conséquence néfaste qui est que ce substrat peut casser à l'endroit des bulles. Par ailleurs, généralement les VIAS ne sont pas réalisés aux endroits du circuit qui chauffent le plus, lesquels se trouvent sous les grilles des transistors à effet de champ par exemple. Les bulles qui apparaissent entre les VIAS se trouvent donc justement de façon néfaste dans les parties qui nécessitent la meilleure dissipation thermique.

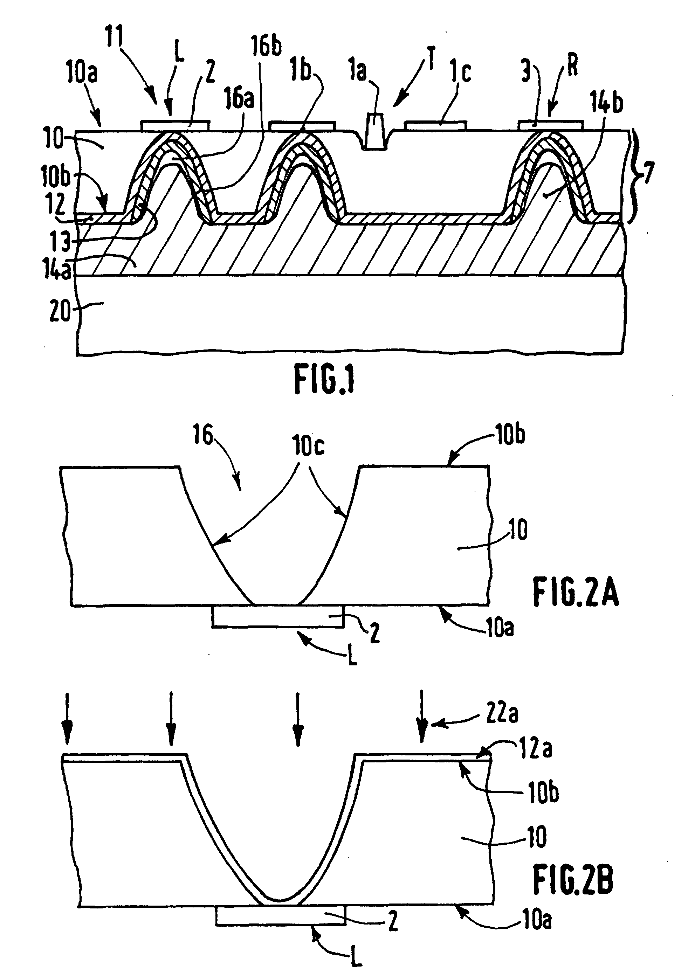

En outre, dans la solution trouvée par le document KOSAKI cité, en référence par exemple à la FIG.1b, la hauteur des parois des VIAS où l'adhérence est permise est grande vis-à-vis de la hauteur totale des VIAS. L'expérience montre qu'il se produit encore des craquelures au niveau de cette région d'adhérence dans l'épaisseur du substrat. Ces craquelures sont à peu près verticales, situées autour des VIAS et généralement ne débouchent pas sur la face avant du dispositif, si bien qu'elles sont invisibles lorsque l'on observe cette face avant. Ces craquelures profondes ont une conséquence néfaste qui est de permettre la diffusion de la soudure dans le matériau formant le substrat, justement vers les régions actives du substrat, résultant en des variations aléatoires néfastes des performances des transistors.

La présente invention propose un dispositif qui ne présente plus ces problèmes techniques. La présente invention propose en outre un procédé de réalisation de ce dispositif qui est particulièrement simple parce qu'il ne comprend pas d'étape de masquage.

Selon l'invention, ces problèmes sont résolus par un dispositif semiconducteur tel que revendiqué à la Revendication 1.

Les avantages résident en ce que :
la partie globulaire de soudure peut monter profondément dans l'ouverture du VIA et donc assurer une meilleure dissipation thermique ;
la partie globulaire de soudure monte dans le VIA sans aucun contact mécanique avec les parois ou le fond du VIA et ne peut donc engendrer de fissures dans le substrat ;
et lorsque le substrat comporte plusieurs VIAS, la répartition de la soudure formant les parties globulaires dans les VIAS est très uniforme, et aucune bulle ne se forme dans la partie planaire entre le substrat et le support.

Ainsi, la soudure entre le substrat et le support est mécaniquement très bonne, et le plan de masse est électriquement très performant en hyperfréquences.

Le procédé de réalisation connu de la référence KOSAKI n'enseigne pas réellement comment souder le substrat sur le support. Ce problème est résolu par un procédé de réalisation d'un dispositif tel que décrit plus haut, revendiqué à la Revendication 9.

Un autre problème résultant du procédé de réalisation connu est qu'un masque est utilisé pour réaliser la couche antiadhérence, qu'il doit être très précis, qu'il est obligatoirement différent pour chaque circuit, et qu'une étape de centrage très précis de ce masque doit être mise en oeuvre.

Selon l'invention, ce problème est résolu par un procédé tel que décrit plus haut comprenant, pour munir la puce d'une couche antiadhésive, des étapes selon la Revendication 10.

Un avantage est que ce procédé fait l'économie d'un circuit de masque et d'une étape de centrage de masque.

Un autre avantage est que ce procédé ne dépend pas du circuit à réaliser car il est strictement le même pour tout circuit associé à un dispositif du type décrit plus haut.

Les figures schématiques illustrant un dispositif et une méthode selon l'invention sont décrites ci-après de façon succinctes :
La FIG.1 représente en coupe un dispositif semiconducteur avec une puce comprenant un circuit sur une face d'un substrat fixé par son autre face, par soudure, sur un support ;
Les FIGs.2 et 3 sont des illustrations en coupe de la méthode de réalisation du dispositif de la FIG.1 dont :

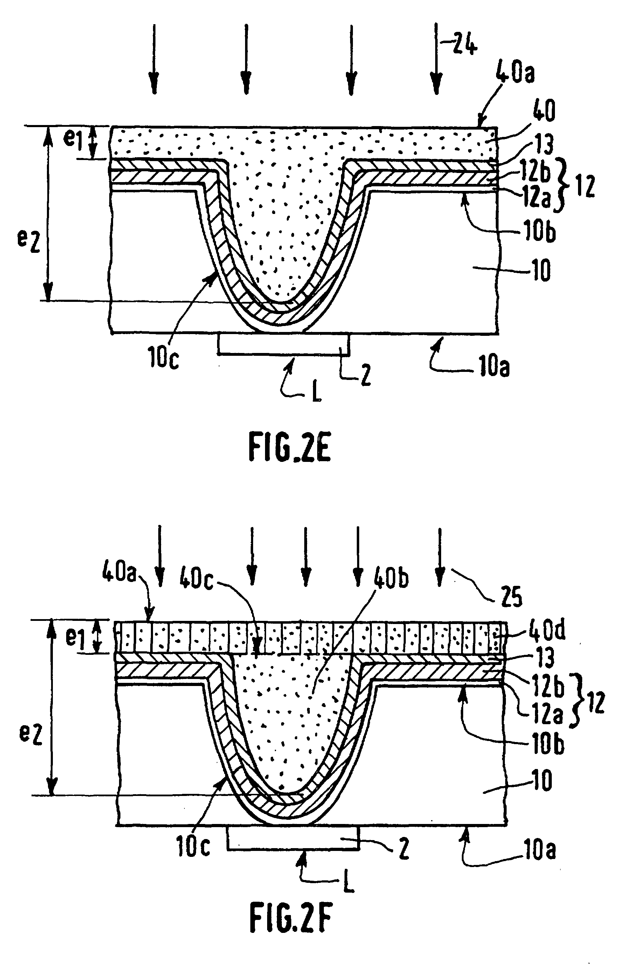

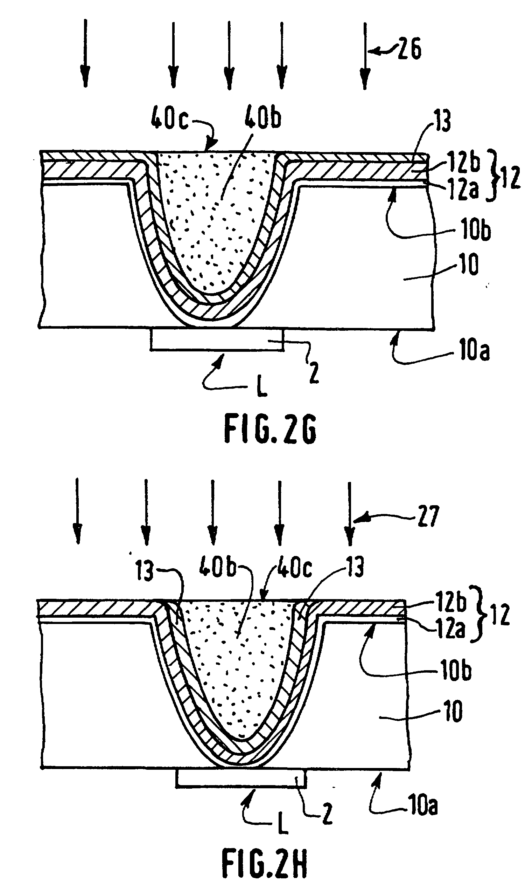

   La FIG.2A illustre la puce après gravure d'un VIA ; la FIG.2B illustre une étape de première métallisation d'un plan de masse ; la FIG.2C illustre une étape de seconde métallisation de plan de masse ; la FIG.2D illustre une étape de réalisation d'une couche antiadhésive ; la FIG.2E illustre une étape de dépôt d'une couche de photorésist planaire ; la FIG.2F illustre une étape d'insolation de la couche de photorésist sans masquage ; la FIG.2G illustre une étape de développement, une forme de la partie insolée de la photorésist ; la FIG.2H illustre une étape de gravure de la couche antiadhésive dans ses zones non protégées par les parties restantes de photorésist ; la FIG.2I illustre le dispositif après élimination de la photorésist ;
   La FIG.3 illustre une puce dans une variante de réalisation ;
Les FIGs.4 sont des illustrations en coupe de la méthode de fixation, par soudure, de la puce des FIG.2I ou FIG.3 sur un support, dont:
   La FIG.4A illustre la mise en présence des constituants de fixation de la puce sur un support ; la FIG.4B illustre le résultat de l'étape de soudure.
La FIG.5A est une photographie d'un VIA en coupe et la FIG.5B un dessin simplifié relatif à la FIG.5A;
La FIG.6A est une photographie d'une partie agrandie de la FIG.5A et la FIG.6B est un dessin simplifié relatif à la FIG.6A ;
La FIG.7 est une photographie d'un dispositif terminé, en coupe.

Un dispositif semiconducteur et une méthode de réalisation de ce dispositif semiconducteur sont décrits ci-après en détail dans une mise en oeuvre préférentielle et dans des variantes, à titre non limitatif.

En référence à la FIG.1, un dispositif semiconducteur comprend une puce 7 fixée par soudure sur un support 20. La puce 7 comprend un substrat semiconducteur 10 ayant une face avant 10a et une face arrière 10b, un élément conducteur 2 d'un circuit électronique 11 sur ladite face avant 10a, une ouverture de VIA 16 s'étendant à travers le substrat, ayant des parois latérales 10c, et un fond 16c coïncidant avec l'élément conducteur 2, une couche conductrice appelée plan de masse 12 couvrant ladite face arrière 10b et les parois latérales 10c et le fond 16c de l'ouverture de VIA et connectant l'élément conducteur.

Ladite puce 7 a en outre une couche appelée antiadhésive 13 déposée sur ledit plan de masse exclusivement à l'intérieur de l'ouverture de VIA, sur le fond 16c et les parois latérales 10c continûment jusqu'à un niveau d'arrêt 40c ou 40c' proche de la face inférieure 10b du substrat.

Ladite puce 7 est fixée audit support 20 au moyen d'une couche d'un matériau de soudure 14 d'un type adhérant au matériau de plan de masse 12, et ne mouillant pas la couche antiadhésive 13. Dans ce système, ladite couche de soudure a une partie planaire 14a entre la face réceptrice 20a du support 20 et la face arrière 10b du substrat, et a une partie globulaire 14b disposée à l'intérieur de l'ouverture de VIA 16,
et un espace libre 16a, 16b est réservé continûment tout autour de ladite partie globulaire 14a, 14c, entre le matériau de soudure et la couche antiadhésive 13 depuis le fond de l'ouverture de VIA jusqu'au dit niveau d'arrêt 40c, 40c' de la couche antiadhésive.

Le circuit 11 peut être dédié à n'importe quel type d'application et comporter toute sorte d'éléments actifs ou passifs, interconnectés avec des lignes microrubans, ou autres conducteurs. Sur la FIG.1, à titre d'exemple, le circuit intégré 11 inclut un transistor à effet de champ T avec une métallisation de grille 1a, un contact ohmique de source 1b, de drain 1c; une résistance R dont une extrémité 3 est représentée ; et une connexion ou ligne hyperfréquence L représentée par la métallisation 2. La couche de métallisation 12 de plan de masse est en contact avec, par exemple, les métallisations 2 de ligne L, 1b de source, 3 de résistance R à travers des ouvertures de VIA 16 pratiquées dans le substrat et s'étendant transversalement de la face arrière 10b à la face avant 10a. La connexion électrique entre les éléments conducteurs du circuit 11 et la métallisation de plan de masse 12 est assurée par la réalisation de manière continue de la métallisation de plan de masse 12 sur les parois 10c des ouvertures de VIA 16.

D'une manière particulière, le circuit électronique est un circuit hyperfréquences, du type monolithiquement intégré (MMIC). Le substrat 10 est semiconducteur ou semi-isolant en un matériau du groupe chimique III-V, par exemple l'arséniure de gallium (GaAs), ou tout autre matériau ayant des propriétés comparables, qui permet d'obtenir des vitesses de commutation très grandes.

Les circuits hyperfréquences en arséniure de gallium sont très petits et très délicats, avec en particulier des transistors ayant des longueurs de grille pouvant atteindre environ 0,1µm. Les propriétés mécaniques des substrats en arséniure de gallium (GaAs) sont par ailleurs bien inférieures à celles des substrats conventionnels en silicium (Si). En particulier, le matériau arséniure de gallium est très cassant.

Par ailleurs, les circuits hyperfréquences requièrent des substrats très minces, le plan de masse de la face arrière devant se trouver à une distance prédéterminée des lignes réalisées sur la face avant.

En addition, les circuits hyperfréquences nécessitent la réalisation de masses électriquement quasiment parfaites. A cet effet, les connexions avec le plan de masse doivent être très courtes et ne pas présenter de discontinuités. C'est pourquoi, la réalisation d'ouvertures de VIAs métallisés, dont les parois sont couvertes d'une métallisation réalisée en continuité avec le plan de masse et à travers le substrat en arséniure de gallium d'épaisseur très faible, est particulièrement favorable.

Maintenant, la fixation par soudure, sur un support d'une telle puce comprenant un circuit délicat réalisé sur un substrat mince et cassant, requiert une grande maîtrise du procédé de soudure, de manière à éviter les problèmes énumérés plus haut.

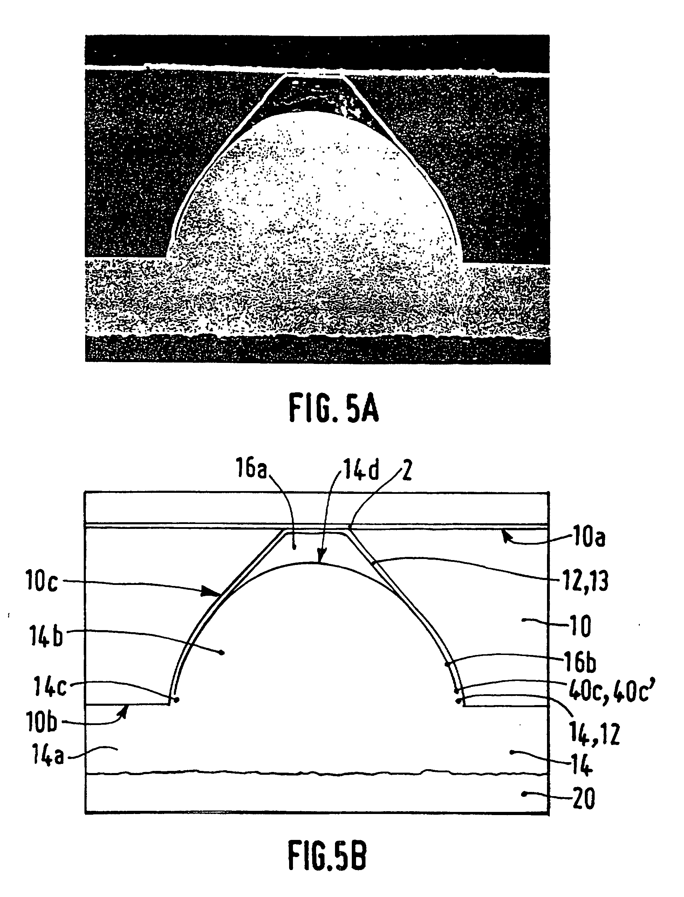

En référence à la FIG.5A qui est une photographie d'un VIA en coupe, réalisée au moyen d'un microscope électronique à balayage à un grandissement environ 400 fois, et en référence à la FIG.5B qui est un dessin simplifié réalisé d'après la photographie de la FIG.5A, on a représenté les différentes parties d'un dispositif selon l'invention fixé sur son support 20. Le dessin de la FIG.5B montre :
en 2, une couche métallique formant un élément de circuit sur la face supérieure 10a d'un substrat semiconducteur 10, ayant une face inférieure 10b ;
en 10c, les parois d'un VIA s'étendant de la face inférieure 10b à la face supérieure 10a à travers le substrat 10 ;
en 12, 13, une couche antiadhésive 13 réalisée en surface d'une couche de plan de masse 12, et qui s'étend substantiellement sur toutes les parois de la cavité du VIA ; la couche 13 s'étend en particulier sur le fond déjà couvert par la métallisation 2, sur les parois 10c depuis la face avant 10a jusqu'à proximité de la face arrière 10b du substrat ; alors que la couche de plan de masse 12 couvre absolument toute la surface de la face arrière 10b, dans les VIAS et hors des VIAS, la couche 13 est arrêtée à peu près au niveau repéré par 40c,40c' à proximité de la face inférieure 10b, de manière à couvrir substantiellement toutes les parois de la cavité du VIA sans excéder cette cavité ;
en 20, le support sur lequel le dispositif 7 incluant le substrat 10 est fixé par soudure par sa face arrière 10b;
en 14, le matériau de soudure qui fixe ledit substrat sur ledit support.

La photographie et le dessin des FIG.5A et 5B montrent en outre que :
la couche de soudure a une épaisseur uniforme entre la face arrière 10b et le support 20 ;
le matériau de soudure emplit substantiellement la cavité du VIA en laissant, à la partie supérieure appelée fond du VIA, un espace libre 16a sur une hauteur de l'ordre de 15 % par rapport à la hauteur du VIA qui est aussi l'épaisseur du substrat 10 ;
le matériau de soudure présente dans le VIA une forme globulaire 14b, avec une partie supérieure 14c en forme de dôme, c'est-à-dire approximativement sphérique et suivant la concavité du VIA ; dans sa partie globulaire 14b, le matériau de soudure suit exactement la forme des parois 10c du VIA sans toutefois avoir aucun contact avec la couche antiadhésive 13 déposée sur le plan de masse 12.

La photographie, reproduite par le dessin, montre très nettement un intervalle de séparation 16b qui s'étend entre l'espace libre 16a et le niveau 40c,40c' correspondant à l'arrêt du dépôt de la couche antiadhésive 13 à proximité de la face arrière 10b.

Les avantages du dispositif selon l'invention, tel que résultant de la photographie 5A et du dessins 5B sont que:
la dissipation thermique est très bonne puisque l'espace libre 16a d'environ 15 % est plus petit que celui de l'état de la technique qui était d'environ 50 % (73,7 µm par rapport à 150 µm), et puisque l'intervalle 16b est quasiment négligeable;
les fissures ne peuvent pas se produire dans le substrat semiconducteur puisque le matériau de soudure 14b de forme globulaire n'est jamais en contact mécanique avec les parois du VIA grâce à l'intervalle 16b;
la hauteur de la partie 14c, au delà du niveau 40c, 40c' où la soudure est occasionnellement en contact avec les parois du VIA est très petite, de l'ordre de 5% de la hauteur totale du VIA, et ne peut induire de fissures dans le substrat

Le dispositif représenté sur la photographie 5A indut :
un substrat 10 en arséniure de gallium d'épaisseur 100 µm ;
une couche de soudure 14 d'épaisseur 35 µm. Cette couche pourrait être évidemment beaucoup plus mince ou plus épaisse ;
un espace libre 16a ayant une hauteur de l'ordre de 15 µm ; la hauteur de cet espace libre peut varier par exemple de quelques % à 25% de la hauteur totale du VIA ;
une masse globulaire de soudure 14b de hauteur environ 85 µm ; cette hauteur varie en conséquence de la hauteur de l'espace libre 16a ;
un intervalle 16b entre la partie globulaire de soudure 14b et la couche antiadhésive 13 de l'ordre de 0,1 à 0,2 µm. La grandeur de cet intervalle peut varier dans une certaine proportion selon la volonté de l'homme du métier ; en général, cet intervalle est inférieur à, ou de l'ordre de 1 µm ;
une distance entre le niveau 40c,40c' d'arrêt de la couche antiadhésive 13 et la face arrière 10b du substrat de l'ordre de 0 à 10 µm, c'est-à-dire de 0 à 10 % de la hauteur du VIA.

La couche 12 de plan de masse est en or (Au), la couche antiadhésive 13 est en titane (Ti) et la couche de soudure 14 est en or-étain (Au-Sn).

Des variantes de ce dispositif sont possibles, notamment dans le choix des matériaux et des dimensions.

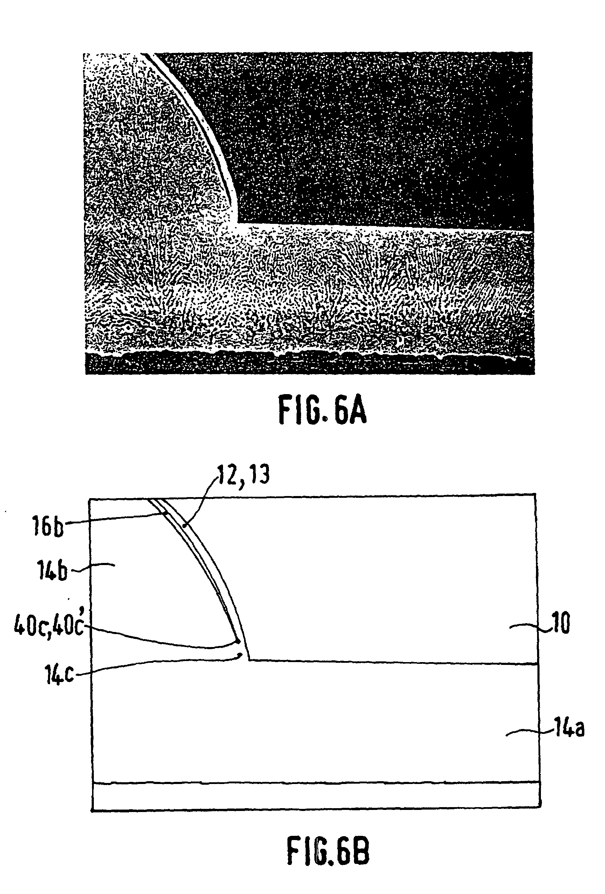

La FIG.6A est une photographie du même VIA que sur la FIG.5A, et représente une partie de ce VIA avec un grandissement plus poussé, environ 625 fois. Le dessin simplifié de la FIG.6B réalisé d'après la photographie de la FIG.6A montre que, au-delà du point 40c,40c' d'arrêt de la couche antiadhésive 13, la soudure 14c, 14a adhère fortement au plan de masse 12 d'une manière telle qu'aucune différence n'est plus visible entre les matériaux 12, 14 dans ces zones. C'est donc bien la couche antiadhésive 13 qui permet de conserver les intervalles 16a,16b entre la masse globulaire de soudure 14b et les parois de la cavité du VIA.

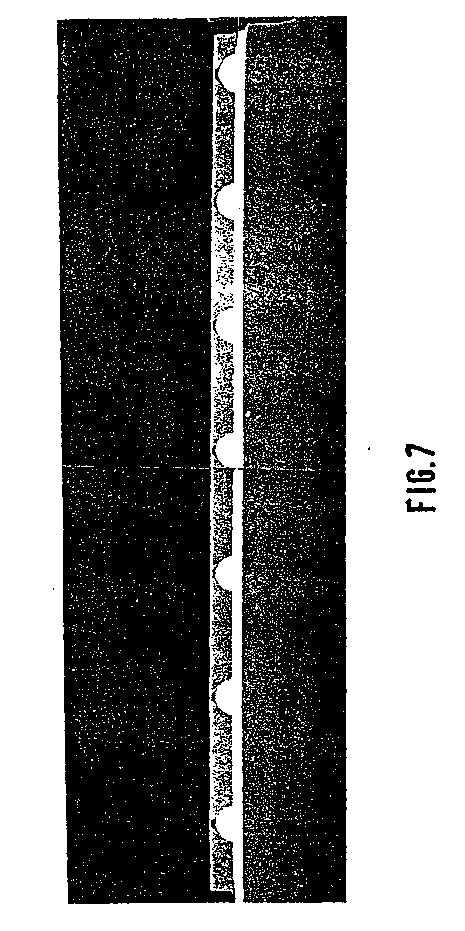

La FIG.7 est une photographie en deux parties adjacentes réalisée au microscope électronique à balayage à un grandissement environ 50 fois, qui montre en coupe un substrat muni de sept VIAS, tous réalisés selon l'invention, ce substrat étant soudé sur son support. Cette photographie met en valeur un avantage de l'invention qui réside dans l'homogénéité de la soudure sur une surface importante. La soudure monte de façon égale dans les VIAS et aucune bulle néfaste n'apparaît.

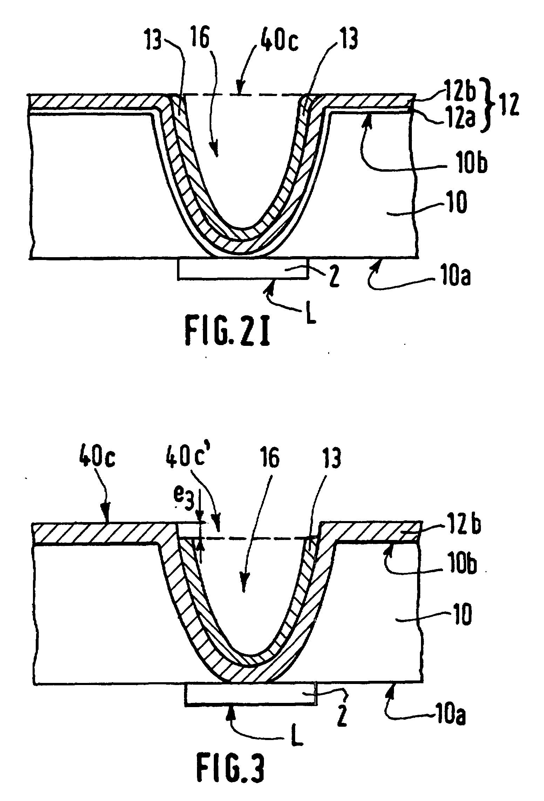

Un procédé de réalisation de la puce et du support comprend des étapes a) à j) et est illustré par les FIG.2A à 2I, et FIG.3.

En référence à la FIG.2A et à la FIG.1, ce procédé comprend d'abord des étapes de :
a) fourniture d'un substrat semiconducteur 10 ayant une face avant 10a et une face arrière 10b, et fourniture d'un support 20 ayant une face réceptrice 20a,
b) fabrication d'un circuit 11 sur la face avant 10a du substrat avec au moins un élément conducteur 2, 1b, ou 3,
c) formation d'au moins une ouverture de VIA (16) s'étendant transversalement à travers le substrat (10) depuis la face arrière (10b) jusqu'à la face avant (10a), en coïncidence avec l'élément de circuit.

La FIG.2A montre le dispositif semiconducteur inversé. Le circuit électronique 11 est par exemple un circuit hyperfréquence du type MMIC réalisé sur la face avant 10a. La face arrière 10b est en haut et le substrat 10 est maintenu de manière appropriée. Dans l'étape c), l'ouverture de VIA est réalisée avec précaution en coïncidence avec un des conducteurs 2, 1b ou 3 par exemple, du circuit 11. Les ouvertures de VIA sont réalisées par exemple par gravure humide au moyen d'un mélange de H₂SO₄, H₂O₂ et H₂O ; ou bien par gravure sèche au moyen d'une gravure ionique réactive RIE. Dans l'exemple décrit, le substrat est en arséniure de gallium GaAs, d'épaisseur environ 100 µm ; le diamètre des ouvertures de VIA du côté de la face arrière 10b est environ 100 µm, par exemple dans une fourchette 50 à 150 µm.

Le procédé comprend ensuite l'étape de :
d) dépôt d'une couche de plan de masse 12 adhérant au matériau semiconducteur, s'étendant sur la face arrière 10b et continûment sur le fond 16c et sur les parois 10c de l'ouverture de VIA, de manière à être en contact électrique avec l'élément conducteur, par exemple 2 du circuit 11 de la face avant 10a.

En référence à la FIG.2B, la formation de la métallisation du plan de masse 12 comprend la formation d'une première couche 12a dite d'accrochage. Dans l'exemple décrit, cette couche 12a d'accrochage est réalisée par pulvérisation cathodique, symbolisée par les flèches 22a, de titane (Ti) dans l'argon (Ar), ce qui évite l'oxydation du titane (Ti). Cette couche a de préférence une épaisseur de 0,1µm, par exemple dans une fourchette de 0,001 à 0,15µm. Pour obtenir l'effet recherché, il est suffisant que cette couche ait une épaisseur supérieure à quelques couches monoatomiques du titane (Ti). En référence à la FIG.2C, la formation de la métallisation de plan de masse 12 comprend la formation d'une deuxième couche 12b formant le plan de masse proprement dit. Dans une variante du procédé, illustrée par la FIG.3, la première couche 12a est absente et la métallisation de plan de masse est uniquement constituée de la seconde couche 12b, simplement notée 12. Dans l'exemple décrit, la seconde couche 12b est réalisée en or (Au) par dépôt électrolytique symbolisé par les flèches 22b. Cette seconde couche 12b a de préférence une épaisseur de 2,5 µm, par exemple dans la fourchette 2 à 3 µm. D'une manière générale, le matériau de métallisation de plan de masse 12 est choisi pour ses propriétés de mouillabilité favorisant l'adhérence avec le matériau de soudure 14.

Le procédé comprend ensuite en référence avec la FIG.2D, pour munir la puce 7 de la couche 13 antiadhésive, l'étape de :
e) dépôt de la couche 13 antiadhésive en un matériau qui adhère au plan de masse 12, et qui s'étend continûment sur ledit plan de masse sur la face arrière 10b et sur le fond 16c et les parois 10c de l'ouverture de VIA.

Le matériau de la couche antiadhésive 13 est choisi pour éviter l'adhérence ultérieure du matériau de soudure 14. La couche antiadhésive peut être par exemple un diélectrique, un matériau plastique, une résine, un verre, ou un métal. De préférence, on choisit le matériau de soudure pour obtenir une synergie de fabrication avec d'autres dispositifs semiconducteurs fabriqués en série. A cet effet, le matériau de soudure est de préférence l'alliage or-étain (Au-Sn) dans les proportions 80-20. Dans ces conditions, un matériau de couche antiadhésive non mouillable par cet alliage, et qui a donné de très bons résultats, est le titane (Ti). En référence à la FIG.2D, la couche antiadhésive est réalisée de préférence en titane (Ti) par pulvérisation cathodique symbolisée par les flèches 23, avec une épaisseur de l'ordre de 0,3 µm. par exemple dans une fourchette 0,2 à 0,5 µm.

En référence aux FIG.2E, 2F respectivement, ce procédé prend maintenant une importance particulière pour procurer un avantage industriel et fournir un dispositif ayant des performances améliorées, et comprend des étapes de :
f) dépôt symbolisé par les flèches 24, sur ladite couche antiadhésive 13, d'une couche de résine photosensible 40, désignée par le terme photorésist, de manière planaire, ayant une surface externe 40a substantiellement plane, pour présenter une première épaisseur e1 relativement faible sur la partie plane de ladite face arrière, et pour présenter une seconde épaisseur e2 plus grande à l'intérieur de l'ouverture de VIA 16. Tout produit opérant le même effet que la résine photosensible 40 peut être utilisé en remplacement.
g) insolation symbolisée par les flèches 25, par un rayonnement à une longueur d'onde appropriée et selon une méthode classique, de toute la surface de ladite couche en photorésist 40, en excluant toute utilisation de masque, sur une épaisseur égale à, ou ne dépassant pas substantiellement ladite première épaisseur e1, de sorte que la partie de couche de photorésist déposée à l'intérieur de l'ouverture de VIA n'est insolée que sur une telle faible épaisseur e1 ou e1 + e3, en surface.

L'insolation opérée uniformément à l'intérieur d'une région 40d d'épaisseur limitée correspondant à la petite épaisseur e1 de la photorésist sur les zones planes de face arrière 10b et à la surface des ouvertures de VIA, est obtenue de façon connue de l'homme du métier par le contrôle de l'énergie d'insolation. Il est important que toute l'épaisseur e1 de photorésist sur les régions planes de la face arrière 10b soit insolée, mais pas substantiellement davantage. On peut admettre une variation de plusieurs µm, par exemple d'environ 5 µm de profondeur d'insolation supplémentaire, telle qu'une profondeur d'insolation comprise entre e1 et e1 + e3 avec e3 = 1 à 10 µm, ce qui est une opération aisée à réaliser pour l'homme du métier. Cette insolation ne nécessite pas de masque dont la réalisation particulière dépendrait de la disposition particulière des ouvertures de VIA pour un circuit particulier, c'est-à-dire d'un masque réalisé spécifiquement par drcuit donné. Elle ne nécessite pas d'opération difficile de centrage de masque. Elle ne dépend pas du circuit.

Le procédé comprend ensuite en référence aux FIG.2G, 2H des étapes de :
h) développement de façon conventionnelle symbolisé par les flèches 26, de la partie insolée 40d de la couche de photorésist 40, laissant subsister une partie non insolée 40b à l'intérieur de l'ouverture de VIA, pour servir de masque à la couche antiadhésive 13 située à l'intérieur de l'ouverture de VIA, à l'exclusion des parties de cette couche situées à l'extérieur du VIA.

Cette partie non insolée 40b a une surface supérieure 40c ou 40c' qui affleure ou qui est légèrement plus basse que la surface externe de la couche antiadhésive 13. L'épaisseur de photorésist dans les ouvertures de VIA est égale à l'épaisseur initiale e2 moins l'épaisseur e1 ou e1+e3 éliminée après insolation en référence à la FIG.2F précédente. La partie 40b de photorésist constitue un masque réalisé sans l'aide d'outil spécifique au circuit donné, qui protège la couche antiadhésive 13 dans l'ouverture de VIA.
i) gravure sélective des parties de couche antiadhésive 13 externes à l'ouverture de VIA, situées sur la partie plane de la face arrière du substrat, en préservant, par la sélectivité de la gravure, la partie de la couche de plan de masse 12 sous-jacente.

En référence à la FIG.2H, les parties de couche antiadhésive 13 non protégées, situées sur les parties planes de la face arrière sont gravées par une gravure sélective symbolisée par les flèches 27, c'est-à-dire par une gravure qui attaque cette couche 13 sans attaquer la couche sous-jacente 12. Dans l'exemple cité, une gravure humide sélective peut être pratiquée avec une solution chimique à base d'acide fluorhydrique (HF), ou bien une gravure sèche RIE peut être menée à bien dans un plasma fluoré.

Le procédé comprend ensuite en référence aux FIG.2I et 3 l'étape de:
j) élimination de façon conventionnelle de la partie de photorésist 40b restant à l'intérieur de l'ouverture de VIA 16.

A l'issue de l'élimination de la photorésist, il reste dans l'ouverture de VIA une partie de la couche antiadhésive 13, strictement limitée à l'intérieur de l'ouverture et ne dépassant pas le niveau 40c ou 40c' correspondant à la profondeur d'insolation. La FIG.3 illustre le cas où cette partie de couche antiadhésive 13 n'atteint que le niveau 40c', lorsque la profondeur d'insolation était de l'ordre de par exemple e1 + 5 µm. Le niveau 40c' est légèrement en retrait à l'intérieur de l'ouverture de VIA.

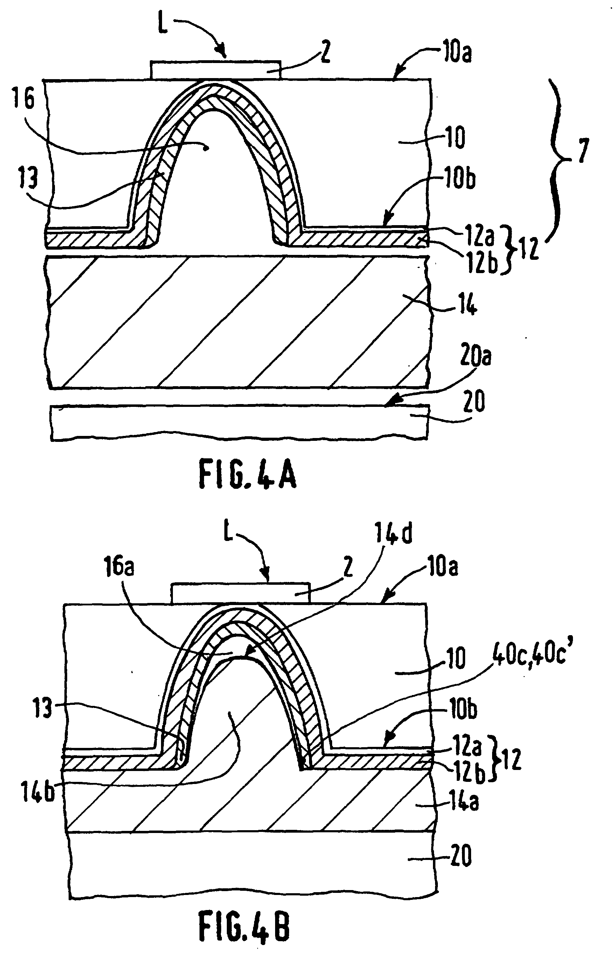

L'opération de fixation par soudure de la puce 7 sur le support 20 est ensuite illustrée par les FIG.4A, 4B, et comprend des étapes k) à n) de :
k) mise en sandwich, entre la face arrière du substrat semiconducteur 10b et la face réceptrice 20a du support 20, d'une couche 14, appelée préforme, d'un matériau approprié à la soudure, le matériau de la couche antiadhésive 13 étant tel qu'il n'est pas mouillable par le matériau 14 de soudure, et le matériau de soudure 14 étant tel qu'il adhère fortement au matériau de plan de masse 12.

En référence à la FIG.4A, la puce 7 est placée avec sa face avant 10a en haut, et sa face arrière en regard de la face 20a réceptrice sur le support 20 qui peut être en tout matériau approprié, tel que l'alumine, par exemple muni d'une couche de métallisation.
l) chauffage du système formé du substrat 10, du support 20 et de la préforme 14 à une température supérieure à la température de fusion du matériau de soudure.

Dans l'exemple cité, où la préforme est en alliage or-étain (Au-Sn), l'ensemble est porté à une température légèrement supérieure à la température de fusion de l'eutectique, de l'ordre de 280°C, pour faire fondre la préforme.
m) application d'une pression uniforme répartie sur l'ensemble de la face avant du substrat, pour presser la préforme 14 entre la face arrière 10b du substrat et la face réceptrice 20a du support, sans laisser substantiellement s'évader le matériau de soudure autour du substrat, pour faire monter le matériau de soudure fondu dans l'ouverture de VIA.

La pression uniforme, de quelques gr. par mm², est appliquée par exemple par l'intermédiaire d'un outil approprié. Des moyens sont appliqués aussi pour empêcher la soudure de s'évader autour du substrat afin de ne pas annuler l'effet de la pression. La valeur de la pression, par exemple de 1 à 50 gr. au mm² est sélectionnée par l'expérience par l'homme du métier de manière appropriée à faire monter le matériau de soudure d'une hauteur convenable dans l'ouverture de VIA. La pression dépend entre autres facteurs de la viscosité de la soudure, du nombre et des dimensions des ouvertures de VIA.
n) refroidissement dudit dispositif.

## Revendications

1. Dispositif semiconducteur comprenant une puce (7) incluant un substrat semiconducteur (10) ayant une face avant (10a) et une face arrière (10b), un élément conducteur (2) d'un circuit sur ladite face avant (10a), une ouverture de VIA (16) s'étendant à travers le substrat, ayant des parois latérales (10c), et un fond (16c) coïncidant avec l'élément conducteur (2), une couche conductrice appelée plan de masse (12) couvrant ladite face arrière et les parois latérales (10c) et le fond (16c) de l'ouverture de VIA et connectant l'élément conducteur et un support (20) avec une face réceptrice (20a) sur laquelle la puce est soudée par sa face arrière, dispositif semiconducteur dans lequel :
ladite puce (7) a en outre une couche appelée antiadhésive (13) déposée sur ledit plan de masse exclusivement à l'intérieur de l'ouverture de VIA, sur le fond (16c) et les parois latérales (10c) continûment jusqu'à un niveau d'arrêt (40c,40c') proche de la face arrière (10b) du substrat,
et ladite puce (7) est fixée audit support (20) au moyen d'une couche d'un matériau de soudure (14) d'un type adhérant au matériau de plan de masse (12), et ne mouillant pas la couche antiadhésive (13), de manière que :
ladite couche de soudure a une partie planaire (14a) entre la face réceptrice (20a) du support (20) et la face arrière (10b) du substrat, et a une partie globulaire (14b) disposée à l'intérieur de l'ouverture de VIA (16),
et un espace libre (16a, 16b) est réservé continûment tout autour de ladite partie globulaire (14a, 14c), entre le matériau de soudure et la couche antiadhésive (13) depuis le fond de l'ouverture de VIA jusqu'au dit niveau d'arrêt (40c, 40c') de la couche antiadhésive,
dispositif **caractérisé en ce que**:
la distance entre le niveau d'arrêt (40c, 40c') de la couche antiadhésive et la face arrière (10b) du substrat est de 0 % exclus à environ 10 % de la hauteur de l'ouverture de VIA ; la partie globulaire de soudure (14a) a un sommet en forme de dôme (14c) vers le fond (16c) de l'ouverture de VIA et l'espace libre (16a) entre le sommet du dôme (14c) et ledit fond (16c) est supérieure à 0 % et inférieure ou égal à 25 % de la hauteur de l'ouverture de VIA; et l'espace libre (16b) entre la partie globulaire (14a) de soudure et les parois latérales (10c) de l'ouverture de VIA est supérieur à 0 % et inférieur ou environ égal à 1 % de ladite hauteur.

2. Dispositif selon la revendication 1, dans lequel le substrat a une épaisseur de 100 µm, le niveau d'arrêt (40c, 40c') de la couche antiadhésive (13) est depuis 0 exclus jusqu'à 10 µm de la face arrière (10b) du substrat, l'espace libre (16a) entre le sommet du dôme (14c) et la couche antiadhésive au fond (16c) de l'ouverture de VIA est supérieure à 0 µm jusqu'à environ 25 µm, l'espace libre (16b) entré la partie globulaire de soudure (14a) et les parois latérales (10c) est supérieure à 0 µm jusqu'à de l'ordre de 1 µm.

3. Dispositif selon la revendication 2, dans lequel le niveau d'arrêt (40c') de la couche antiadhésive par rapport à la face arrière (10b) du substrat est environ 5 µm, l'espace libre (16a) entre le sommet du dôme (14c) et la couche antiadhésive (13) est environ 15 µm, et l'espace libre (16b) entre la partie globulaire de soudure (14a) et les parois latérales (10c) est environ 0,1 µm à 0,5 µm.

4. Dispositif semiconducteur selon l'une des revendications 1 à 3, dans lequel la couche antiadhésive (13) est en un matériau conducteur.

5. Dispositif semiconducteur selon la revendication 4, dans lequel le matériau conducteur de la couche antiadhésive (13) est du titane (Ti) et le matériau de soudure (14) est un alliage or-étain (Au-Sn).

6. Dispositif semiconducteur selon la revendication 5, dans lequel la couche de plan de masse (12) inclut une fine couche (12a) en titane-or (Ti-Au) pour l'accrochage sur le matériau semiconducteur, déposée préalablement à une couche conductrice (12b) en or (Au).

7. Dispositif selon l'une des revendications 1 à 6 dans lequel le substrat semiconducteur (10) est fabriqué en un matériau du groupe chimique III - IV.

8. Dispositif selon la revendication 7, dans lequel le circuit disposé sur la face avant (10a) de la puce (7) est un circuit hyperfréquences monolithiquement intégré (MMIC), et le substrat (10) est en arséniure de gallium (GaAs).

9. Procédé de réalisation d'un dispositif semiconducteur conforme au dispositif selon l'une des revendications 1 à 8 comprenant des étapes (a à j) pour fournir une puce (7) incluant un substrat semiconducteur (10) ayant des faces appelées avant (10a) et arrière (10b), un élément conducteur (2) d'un circuit disposé sur ladite face avant (10a), une ouverture de VIA (16) s'étendant à travers l'épaisseur du substrat, ayant des parois latérales (10c), et un fond (16c) coïncidant avec ledit élément conducteur (2), un plan de masse (12) couvrant ladite face arrière et les parois latérales (10c) et le fond (16c) de l'ouverture de VIA et contactant électriquement l'élément conducteur, et un support (20) avec une face réceptrice (20a) sur laquelle la puce est soudée par sa face arrière, et ladite puce incluant aussi une couche appelée antiadhésive (13) déposée sur le plan de masse exclusivement à l'intérieur de l'ouverture de VIA, sur le fond (16c) et sur les parois latérales (10c) continûment jusqu'à un niveau d'arrêt (40c, 40c'), dispositif dans lequel:
la distance entre le niveau d'arrêt (40c, 40c') de la couche antiadhésive et la face arrière (10b) du substrat est de 0 % exclus à environ 10 % de la hauteur de l'ouverture de VIA ; la partie globulaire de soudure (14a) a un sommet en forme de dôme (14c) vers le fond (16c) de l'ouverture de VIA et l'espace libre (16a) entre le sommet du dôme (14c) et ledit fond (16c) est supérieure à 0 % et inférieure ou égal à 25 % de la hauteur de l'ouverture de VIA ; et l'espace libre (16b) entre la partie globulaire (14a) de soudure et les parois latérales (10c) de l'ouverture de VIA est supérieur à 0 % et inférieur ou environ égal à 1 % de ladite hauteur,
ce procédé comprenant en outre, pour souder la puce (7) sur le support (20), des étapes de :
k) mise en sandwich, entre la face arrière du substrat semiconducteur (10b) et la face réceptrice (20a) du support (20), d'une couche (14), appelée préforme, d'un matériau approprié à la soudure, le matériau de la couche antiadhésive (13) étant tel qu'il n'est pas mouillable par le matériau (14) de soudure, et le matériau de soudure (14) étant tel qu'il adhère fortement au matériau de plan de masse (12),
l) chauffage du système formé du substrat (10), du support (20) et de la préforme (14) à une température supérieure à la température de fusion du matériau de soudure,
m) application d'une pression uniforme répartie sur l'ensemble de la face avant du substrat, pour presser la préforme entre la face arrière du substrat (10b) et la face réceptrice (20a) du support, sans laisser substantiellement s'évader le matériau de soudure autour du substrat, pour faire monter le matériau de soudure fondu dans l'ouverture de VIA,
n) refroidissement du dispositif ainsi formé.

10. Procédé selon la revendication 9, comprenant pour munir la puce (7) de la couche antiadhésive (13), des étapes de :
e) dépôt de la couche (13) antiadhésive en un matériau qui adhère au plan de masse (12), et qui s'étend continûment sur ledit plan de masse sur la face arrière (10b) et sur le fond (16c) et les parois (10c) de l'ouverture de VIA,
f) dépôt sur ladite couche antiadhésive (13) d'une couche de résine photosensible (40), appelée photorésist, de manière planaire, ayant une surface externe substantiellement plane, pour présenter une première épaisseur (e1) relativement faible sur la partie plane de ladite face arrière, et pour présenter une seconde épaisseur (e2) plus grande à l'intérieur de l'ouverture de VIA (16),
g) insolation de toute la surface de ladite couche en photorésist (40), en excluant toute utilisation de masque, sur une épaisseur égale à, ou ne dépassant pas substantiellement ladite première épaisseur (e1), de sorte que la partie de couche de photorésist déposée à l'intérieur de l'ouverture de VIA n'est insolée que sur une telle faible épaisseur (e1, e1 + e3), en surface,
h) développement de la partie insolée (40d) de la couche de photorésist (40), laissant subsister une partie non insolée (40b) à l'intérieur de l'ouverture de VIA, pour servir de masque à la couche antiadhésive située à l'intérieur de l'ouverture de VIA, à l'exclusion des parties de cette couche situées à l'extérieur du VIA,
i) gravure sélective des parties de couche antiadhésive (13) externes à l'ouverture de VIA, situées sur la partie plane de la face arrière du substrat, en préservant, par la sélectivité de la gravure, la partie de la couche de plan de masse (12) sous-jacente,
j) élimination de la partie de photorésist (40b) restant à l'intérieur de l'ouverture de VIA (16).

11. Procédé selon la revendication 10, comprenant pour former la puce (7) et le support (20) des étapes de :
a) fourniture d'un substrat semiconducteur (10) ayant une face avant (10a) et une face arrière (10b), et fourniture d'un support (20) ayant une face réceptrice (20a),
b) fabrication d'un circuit (11) sur la face avant (10a) du substrat, avec un élément conducteur (2, 1b, 3),
c) formation d'au moins une ouverture de VIA (16) s'étendant transversalement à travers le substrat (10) depuis la face arrière (10b) jusqu'à la face avant (10a), en coïncidence avec l'élément conducteur de circuit,
d) dépôt d'une couche de plan de masse (12) adhérant au matériau semiconducteur, s'étendant sur la face arrière (10b) et continûment sur le fond (16c) et sur les parois (10c) de l'ouverture de VIA, connectant l'élément conducteur du circuit de la face avant.

12. Procédé selon l'une des revendications 10 à 11, dans lequel dans l'étape m) la pression exercée est de l'ordre de 1 à 50 g au mm².

## Patentansprüche

1. Halbleiteranordnung mit einem ein Halbleitersubstrat (10) aufweisenden Chip (7) mit einer Vorder- (10a) und einer Rückseite (10b), einem Leiterelement (2) einer Schaltung auf der besagten Vorderseite (10a), einer durch das Substrat verlaufenden Durchgangsleitung (16) mit Seitenwänden (10c), und einem Grund (16c), mit dem Leiterelement (2) übereinstimmend, einer mit Massefläche (12) bezeichneten Leiterschicht, die die besagte Rückseite und die Seitenwände (10c) sowie den Grund (16c) der Durchgangsleitung abdeckt und das Leiterelement anschließt, und einem Träger (20) mit einer dafür vorgesehenen Aufnahmeseite (20a), den Chip mit seiner Rückseite darauf zu löten, Halbleiteranordnung, in der:
der besagte Chip (7) zudem eine sogenannte Antihaftschicht (13) hat, auf die besagte Massefläche ausschließlich im Innern der Öffnung der Durchgangsleitung aufgebracht, auf den Grund (16c) und die Seitenwände (10c) und durchgehend bis zu einer Unterbrechungsebene (40c, 40c') nahe der Rückseite (10b) des Substrats,
und der besagte Chip (7) auf dem besagten Träger (20) mit einer Schicht eines Lötmaterials (14) eines auf dem Material der Massefläche (12), aber nicht auf der Antihaftschicht (13) haftenden Typs befestigt ist, derart, daß
die besagte Lötschicht einen flachen Teil (14a) zwischen der Aufnahmeseite (20a) des Trägers (20) und der Rückseite (10b) des Substrats hat, und einen kugelförmigen Teil (14b), im Innern der Öffnung der Durchgangsleitung (16) aufgebracht,
und ein Freiraum (16a, 16b) ist durchgehend um den besagten kugelförmigen Teil (14a, 14c) vorbehalten, zwischen dem Lötmaterial und der Antihaftschicht (13) vom Grund der Öffnung der Durchgangsleitung bis zu der besagten Unterbrechungsebene (40c, 40c') der Antihaftschicht,
**dadurch gekennzeichnete** Anordnung, daß
die Distanz zwischen der Unterbrechungsebene (40c, 40c') der Antihaftschicht und der Rückseite (10b) des Substrats 0% ausschließlich ca. 10% der Öffnungshöhe der Durchgangsleitung beträgt; der kugelförmige in Teil des Lots (14a) eine Spitze in Kuppelform (14c) zum Grund (16c) der Öffnung der Durchgangsleitung hat, und der Freiraum (16a) zwischen der Kuppelspitze (14c) und dem besagten Grund (16c) über 0% und unter oder gleich 25% der Öffnungshöhe der Durchgangsleitung beträgt; und der Freiraum (16b) zwischen dem kugelförmigen Teil (14a) des Lots und den Seitenwänden (10c) der Öffnung der Durchgangsleitung über 0% und unter ca. 1% der besagten Höhe beträgt.

2. Anordnung nach Anspruch 1, in der das Substrat eine Dicke von 100 µm hat, die Unterbrechungsebene (40c, 40c) der Antihaftschicht (13) von 0 bis 10 µm von der Rückseite (10b) des Substrats ausgeschlossen ist, der Freiraum (16a) zwischen der Kuppelspitze (14c) und der Antihaftschicht des Grunds (16c) der Öffnung der Durchgangsleitung über 0 µm bis ca. 25 µm liegt, der Freiraum (16b) zwischen dem kugelförmigen Lotteil (14a) und den Seitenwänden (10c) über 0 µm und bis zur Größenordnung von 1 µm beträgt.

3. Anordnung nach Anspruch 2, in der die Unterbrechungsebene (40c') der Antihaftschicht in bezug auf die Rückseite (10b) des Substrats ca. 5 µm beträgt, der Freiraum (16a) zwischen der Kuppelspitze (14c) und der Antihaftschicht (13) ca. 15 µm beträgt, und der Freiraum (16b) zwischen dem kugelförmigen Lotteil (14a) und den Seitenwänden (10c) ca. 0,1 µm bis 0,5 µm beträgt.

4. Halbleiteranordnung nach einem der Ansprüche 1 bis 3, in der die Antihaftschicht (13) aus einem Leitermaterial ist.

5. Halbleiteranordnung nach Anspruch 4, in der das Leitermaterial der Antihaftschicht 13 aus Titan (Ti) ist, und das Lötmaterial (14) aus einer Gold-Zinn-Legierung (Au-Sn) ist.

6. Halbleiteranordnung nach Anspruch 5, in der die Massefläche (12) eine feine Schicht (12a) aus Titan-Gold (Ti-Au) als Haftmaterial auf dem Halbleiter enthält, vor einer Leiterschicht (12b) aus Gold (Au) aufgebracht.

7. Anordnung nach einem der Ansprüche 1 bis 6, in der das Halbleitersubstrat (10) auf einem Material der chemischen Gruppe III-IV gefertigt wird.

8. Anordnung nach Anspruch 7, in der die auf die Vorderseite (10a) des Chips (7) gebrachte Schaltung eine integrierte monolithische Hyperfrequenzschaltung (MMIC) ist, und das Substrat (10) aus Galliumarsenid (GaAs) ist.

9. Verfahren zur Herstellung einer Halbleiteranordnung gemäß der Anordnung einer der Ansprüche 1 bis 8 mit Schritten (a bis j) zur Bereitstellung eines Chips (7) mit einem Halbleitersubstrat (10) mit einer sogenannten Vorderseite (10a) und einer Rückseite (10b), einem Leiterelement (2) einer elektronischen Schaltung auf der besagten Vorderseite (10a), eine Öffnung für eine Durchgangsleitung (16) durch die Dicke des Substrats, mit Seitenwänden (10c) und einem Grund (16c), mit dem Leiterelement (2) übereinstimmend, einer mit Massefläche (12), die die besagte Rückseite und die Seitenwände (10c) sowie den Grund (16c) der Öffnung der Durchgangsleitung abdeckt und das Leiterelement elektrisch anschließt, und einem Träger (20) mit einer Aufnahmeseite (20a), auf die der Chip mit seiner Rückseite gelötet wird, wobei der besagte Chip auch eine sogenannte Antihaftschicht (13) umfaßt, auf die besagte Massefläche ausschließlich im Öffnungsinnern der Durchgangsleitung aufgebracht, auf den Grund (16c) und auf die Seitenwände (10c) und durchgehend bis zu einer Unterbrechungsebene (40c, 40c'), wobei in der Anordnung:
die Distanz zwischen der Unterbrechungsebene (40c, 40c') der Antihaftschicht und der Rückseite (10b) des Substrats 0% ausschließlich ca. 10% der Öffhungshöhe der Durchgangsleitung beträgt; der kugelförmige in Teil des Lots (14a) eine Spitze in Kuppelform (14c) zum Grund (16c) der Öffnung der Durchgangsleitung hat, und der Freiraum (16a) zwischen der Kuppelspitze (14c) und dem besagten Grund (16c) über 0% und unter oder gleich 25% der Öffnungshöhe der Durchgangsleitung beträgt; und der Freiraum (16b) zwischen dem kugelförmigen Teil (14a) des Lots und den Seitenwänden (10c) der Öffnung der Durchgangsleitung über 0% und unter ca. 1% der besagten Höhe beträgt,
dieses Verfahren zudem zum Löten des Chips (7) auf den Träger (20) Schritte umfaßt, zum:
k) Einfügen, zwischen der Rückseite des Halbleitersubstrats (10b) und der Aufnahmeseite (20a) des Trägers (20), einer mit Vorform bezeichneten Schicht (14) aus einem zum Löten geeigneten Material, wobei das Material der Antihaftschicht (13) derart ist, um nicht an dem Lötmaterial (14) haften zu können, und das Lötmaterial (14) derart ist, um sehr stark an dem Material der Massefläche (12) zu haften,
l) Erhitzen des vom Substrat (10) gebildeten Systems, des Trägers (20) der Vorform (14), auf eine Temperatur über der Schmelztemperatur des Lötmaterials,
m) Anwenden eines gleichmäßig über die gesamte vordere Substratseite verteilten Drucks, um die Vorform zwischen die hintere Substratseite (10b) und die Aufnahmeseite (20a) des Trägers zu drücken, ohne wesentlich Lötmaterial um das Substrat entweichen zu lassen, um das geschmolzene Lötmaterial in die Öffnung der Durchgangsleitung steigen zu lassen,
n) Abkühlen der so gebildeten Anordnung.

10. Verfahren nach Anspruch 9, mit Schritten, um den Chip (7) mit der Antihaftschicht (13) zu versehen, zum:
e) Aufbringen der Antihaftschicht (13) aus einem Material, das auf der Massefläche (12) haftet und sich durchgehend auf der besagten Massefläche über die Rückseite (10b) und den Grund (16c) und die Wände (10c) der Öffnung der Durchgangsleitung erstreckt,
f) Aufbringen auf die besagte Antihaftschicht (13) einer Fotoharzschicht (40), mit Fotoresist bezeichnet, eben und mit einer weitgehend flachen Außenfläche, um eine erste, relativ geringfügige Dicke (e1) auf dem flachen Teil der besagten Rückseite zu bilden, und um eine zweite, bedeutendere Schicht (e2) im Innern der Öffnung der Durchgangsleitung (16) zu erhalten,
g) Insolation der Gesamtfläche der besagten Fotoresistschicht (40), ohne jegliche Verwendung einer Maske, über eine Dicke gleich oder nicht wesentlich größer als die besagte erste Dicke (el ), damit der Teil der im Innern der Öffnung der Durchgangsleitung aufgebrachten Fotoresistschicht nur über die geringfügige Dicke (el, el + e3) auf der Oberfläche insoliert wird,
h) Entwickeln des insolierten Teils (40d) der Fotoresistschicht (40), wobei ein nicht insolierter Teil (40b) im Innern der Öffnung der Durchgangsleitung belassen wird, um der im Innern der Öffnung der Durchgangsleitung gelegenen Antihaftschicht als Maske zu dienen, ausschließlich der außerhalb der Durchgangsleitung gelegenen Teile dieser Schicht,
i) selektiven Gravieren der zur Öffnung der Durchgangsleitung externen Teile der Antihaftschicht (13), an dem flachen Teil der Rückseite des Substrats gelegen, unter Erhalt, durch selektive Gravur, des darunter liegenden Teils der Masseflächenschicht (12),
j) Entfernen des im Innern der Öffnung der Durchgangsleitung (16) verbleibenden Fotoresistteils (40b).

11. Verfahren nach Anspruch 10, mit Schritten zur Bildung des Chips (7) und des Trägers (20), zum:
a) Bereitstellen eines Halbleitersubstrats (10) mit einer Vorderseite (10a) und einer Rückseite (10b), und Bereitstellung eines Trägers (20) mit einer Aufnahmeseite (20a),
b) Fertigen einer Schaltung (11) auf der Vorderseite (10a) des Substrats mit mindestens einem Leiterelement (2, 1b, 3),
c) Bilden mindestens einer Durchgangsleitung (16), die sich von der Rückseite (10b) bis zur Vorderseite (10a) quer durch das Substrat (10) erstreckt und mit dem Schaltungselement übereinstimmt,
d) Aufbringen einer Masseflächenschicht (12), die auf dem Halbleitermaterial haftet, sich über die Rückseite (10b) und durchgehend über den Grund (16c) und die Wände (10c) der Öffnung der Durchgangsleitung erstreckt, um einen elektrischen Kontakt mit dem Leiterelement der Schaltung der Vorderseite herzustellen.

12. Verfahren nach einem der Ansprüche 10 bis 11, in dem der Schritt m) des angelegten Druckes der Größenordnung von 1 bis 50 g pro mm² beträgt.

## Claims

1. A semiconductor device comprising a chip (7), with a semiconductor substrate (10) having a front surface (10a) and a rear surface (10b), a conductor element (2) of a circuit on said front surface (10a), a via opening (16) extending through the substrate and having lateral walls (10c) and a bottom (16c) which coincides with the conductor element (2), a conductive layer or ground plane (12) covering said rear surface and the lateral walls (10c) and the bottom (16c) of the via opening and forming a connection to the conductor element, and a support (20) with a receiving surface (20a) on which the chip is soldered by its rear surface, wherein
said chip (7) in addition comprises a layer called anti-adhesion layer (13) which is deposited on said ground plane exclusively inside the via opening, provided continuously over the bottom (16c) and the lateral walls (10c) up to a stopping level (40c, 40c') which lies close to the rear surface (10b) of the substrate,
and said chip (7) is fixed to said support (20) by means of a layer of a soldering material (14) of a type which adheres to the ground plane material (12) and does not wet the anti-adhesion layer (13), such that:
said layer of soldering material (14) has a planar portion (14a) between the receiving surface (20a) of the support (20) and the rear surface (10b) of the substrate, and has a globular portion (14b) which is present inside the via opening (16),
and a free space (16a, 16b) is maintained continuously around said globular portion (14a, 14c) between the soldering material and the anti-adhesion layer (13) from the bottom of the via opening up to said stopping level (40c, 40c') of the anti-adhesion layer, which device is **characterized in that** the distance between the stopping level (40c, 40c') of the anti-adhesion layer and the rear surface (10b) of the substrate lies between 0% and approximately 10% of the height of the via opening; the globular solder portion (14a) has a top in the shape of a dome (14d) towards the bottom (16c) of the via opening, and the free space (16a) between the top of the dome (14d) and said bottom (16c) is greater than 0% and smaller than or equal to 25% of the height of the via opening; and the free space (16b) between the globular solder portion (14a) and the lateral walls (10c) of the via opening is greater than 0% and smaller than or approximately equal to 1% of said height.

2. A device as claimed in Claim 1, wherein the substrate has a thickness of 100 µm, the stopping level (40c, 40c') of the anti-adhesion layer (13) lies between 0 and 10 µm from the rear surface (10b) of the substrate, the free space (16a) between the top of the dome (14d) and the anti-adhesion layer at the bottom (16c) of the via opening is greater than 0 µm up to approximately 25 µm, and the free space (16b) between the globular solder portion (14a) and the lateral walls (10c) is greater than 0 µm up to the order of 1 µm.

3. A device as claimed in Claim 2, wherein the stopping level (40c') of the anti-adhesion layer is approximately 5 µm from the rear surface (10b) of the substrate, the free space (16a) between the top of the dome (14d) and the anti-adhesion layer (13) is approximately 15 µm, and the free space (16b) between the globular solder portion (14a) and the lateral walls (10c) is approximately 0.1 µm to 0.5 µm.

4. A semiconductor device as claimed in any one of the Claims 1 to 3, wherein the anti-adhesion layer (13) is made of a conductor material.

5. A semiconductor device as claimed in Claim 4, wherein the conductor material of the anti-adhesion layer (13) is titanium (Ti), and the soldering material (14) is a gold-tin (Au-Sn) alloy.

6. A semiconductor device as claimed in Claim 5, wherein the ground plane layer (12) includes a thin layer (12a) of titanium-gold (Ti-Au) for bonding to the semiconductor material and deposited prior to a conductive layer (12b) of gold (Au).

7. A device as claimed in any one of the Claims 1 to 6, wherein the semiconductor substrate (10) is manufactured from a material of the chemical group III-V.

8. A device as claimed in Claim 7, wherein the circuit arranged on the front surface (10a) of the chip (7) is a monolithically integrated microwave frequency circuit (MMIC), and the substrate (10) is made of gallium arsenide (GaAs).

9. A method of realizing a semiconductor device of the kind as claimed in any one of the Claims 1 to 8, comprising steps (a to j) for providing a chip (7) comprising a semiconductor substrate (10) having a front (10a) and rear (10b) surface, a conductor element (2) of a circuit arranged on said front surface (10a), a via opening (16) extending through the thickness of the substrate and having lateral walls (10c), and a bottom (16c) coinciding with said conductor element (2), a ground plane (12) covering said rear surface and the lateral walls (10c) and the bottom (16c) of the via opening and making electrical contact with the conductor element, and a support (20) with a receiving surface (20a) to which the chip is soldered by its rear surface, said chip also comprising a layer called anti-adhesion layer (13) deposited on the ground plane exclusively inside the via opening on the bottom (16c) and on the lateral walls (10c) in a continuous manner up to a stopping level (40c, 40c') adjacent the rear surface (10b) of the substrate, in which device:
the distance between the stopping level (40c, 40c') of the anti-adhesion layer and the rear surface (10b) of the substrate is between 0 and 10% of the height of the via opening; the globular portion (14a) of the solder has a top in the shape of a dome (14c) towards the bottom (16c) of the via opening and the free space (16a) between the top of the dome (14c) and said bottom (16c) is greater than 0% and smaller than or equal to 25% of the height of the via opening; and the free space (16b) between the globular solder portion (14a) and the lateral walls (10c) of the via opening is greater than 0% and smaller than or approximately equal to 1% of said height,
which process in addition comprises the following steps for soldering the chip (7) on the support (20):
k) sandwiching a layer (14), called preform layer, of a material suitable for soldering between the rear surface (10b) of the semiconductor substrate and the receiving surface (20a) of the support (20) of, while the material of the anti-adhesion layer (13) is such that it cannot be wetted by the soldering material (14), and the soldering material (14) is such that it adheres strongly to the material of the ground plane (12),
l) heating of the system formed by the substrate (10), the support (20), and the preform (14) to a temperature higher than the fusion temperature of the soldering material,
m) applying a uniform pressure distributed over the entire front surface of the substrate for compressing the preform between the rear surface (10b) of the substrate and the receiving surface (20a) of the support, substantially without allowing soldering material to escape around the substrate, so as to cause the molten soldering material to rise in the via opening, and
n) cooling-down of the device thus formed.

10. A method as claimed in Claim 9, comprising the following steps for providing the chip (7) with the anti-adhesion layer (13):
e) deposition of the anti-adhesion layer (13) made of a material which adheres to the ground plane (12) and which extends continuously over said ground plane on the rear surface (10b) and on the bottom (16c) and walls (10c) of the via opening,
f) deposition on said anti-adhesion layer (13) of a layer of photosensitive resin (40), called photoresist, in a planar manner, having an outer surface which is substantially planar so as to have a first thickness (e1) which is comparatively small on the planar portion of said rear surface and a second, greater thickness (e2) inside the via opening (16),
g) irradiation of the entire surface of said photoresist layer (40), without the use of any mask, over a thickness equal to or at least not substantially exceeding said first thickness (e1), such that the portion of the photoresist layer deposited inside the via opening is irradiated over a small thickness (e1, e1 + e3) only, at its surface,
h) development of the irradiated portion (40d) of the photoresist layer (40), whereby a non-irradiated portion (40b) remains inside the via opening for serving as a mask for the anti-adhesion layer lying inside the via opening, but not for the portions of this layer situated outside the via,
i) selective etching of the portions of the anti-adhesion layer (13) lying outside the via opening, i.e. lying on the planar portion of the rear surface of the substrate, the subjacent portion of the ground plane layer (12) being preserved owing to the selectivity of the etching process, and
j) elimination of the photoresist portion (40b) remaining inside the via opening (16).

11. A method as claimed in Claim 10, comprising the following steps for forming the chip (7) and the support (20):
a) provision of a semiconductor substrate (10) having a front surface (10a) and a rear surface (10b), and provision of a support (20) having a receiving surface (20a),
b) manufacture of a circuit (11) on the front surface (10a) of the substrate, with a conductor element (2, 1b, 3),
c) formation of at least one via opening (16) which extends transversely through the substrate (10) from the rear surface (10b) to the front surface (10a), so as to coincide with the conductor element of the circuit, and
d) deposition of a layer for a ground plane (12) which adheres to the semiconductor material, which extends over the rear surface (10b) and continues over the bottom (16c) and the walls (10c) of the via opening, connecting the conductor element of the circuit to the front surface.

12. A method as claimed in any one of the Claims 10 to 11, wherein the pressure exerted in step m) is of the order of 1 to 50 g per mm².
